Europäisches Patentamt

European Patent Office

Office européen des brevets

(11) Publication number: **0 476 685 A2**

# EUROPEAN PATENT APPLICATION

(21) Application number: **91116034.9**

(22) Date of filing: **20.09.91**

(51) Int. Cl.⁵: **G11C 5/00**

(30) Priority: **21.09.90 JP 250395/90**

(43) Date of publication of application:
**25.03.92 Bulletin 92/13**

(84) Designated Contracting States:
**DE FR GB**

(71) Applicant: **Kabushiki Kaisha Toshiba**
**72, Horikawa-cho Saiwai-ku**
**Kawasaki-shi(JP)**
Applicant: **TOSHIBA MICRO-ELECTRONICS**
**CORPORATION**
**25-1, Ekimaehoncho**
**Kawasaki-ku Kawasaki-shi(JP)**

(72) Inventor: **Katsumata, Akio, c/o Intellectual**
**Prop. Division**
**Kabushiki Kaisha Toshiba, 1-1 Shibaura**
**1-chome**
**Minato-ku, Tokyo 105(JP)**
Inventor: **Tanimoto, Hideshi, c/o Intellectual**
**Prop. Division**
**Kabushiki Kaisha Toshiba, 1-1 Shibaura**
**1-chome**
**Minato-ku, Tokyo 105(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) **Thin memory module.**

(57) The thin-type memory module according to the present invention comprises a substrate to be set to a socket provided on a mother board, and semiconductor devices each made of a thin-type package, mounted on one of or both surfaces of said substrate. The semiconductor device used should most preferably be of a thin-type small outline package. The definition of a thin-type package is that a package the thickness of which defined between the surface of the substrate and the upper most portion of the package is no more than 1.2 mm. Generally, a plurality of sockets are set to a mother board.

FIG. 7

The present invention relates to a thin-type single in-line memory module (SIMM), especially to that used in a work station, personal computer, or the like.

Conventional work stations and personal computers as hardware have a structure in which a plurality of sockets, to which SIMMs are set, are provided on a substrate (to be called mother board hereinafter). Figs. 1 to 3 are examples of the sockets to which SIMMs are set, more specifically, 30 pin type SIMM module sockets (Pitch P = 2.54 mm, two-row straight type). Fig. 1 shows a one-side type socket; Fig. 2 shows a both-side type; and Fig. 3 shows a low-profile type.

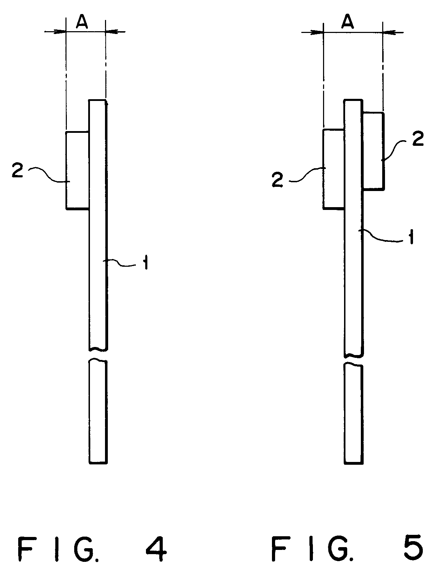

Figs. 4 and 5 each show a structure of an SIMM. Fig. 4 is a one-side type SIMM, and Fig. 5 is a both-side type. As shown in these figures, chip condensers and memory ICs 2 are mounted on the surface of a print substrate 1. When memory ICs and other elements are arranged on the surface of the print substrate 1, the size of the mother board can be made smaller, as compared to the case where the memory ICs and others are mounted directly on the mother board. Thus, high density mounting of memory ICs and other elements on a board can be achieved.

However, the pitch of the sockets provided on the mother board is determined by the thickness of each of the SIMMs, and the interval between each adjacent pair of SIMMs. Generally, the intervals between each adjacent pair of SIMMs are 7.62 mm (average) for those of the one side type, 10.16 mm (average) for those of the both side type, and 12.7 mm (average) for those of the low profile type. The thickness A of an SIMM, as shown in Fig. 4, is determined by the thickness of the print substrate 1, and the thickness of the packages of the memory ICs 2. As a package of the memory IC 2, a small outline J lead package (to be called SOJ hereinafter), or a small outline package (to be called SOP hereinafter), and the like are generally used.

Although an increase in integration density of a mother board is somehow possible by reducing its socket pitch, the thickness of the above-mentioned SOJ or SOP is the main determinant of the socket pitch in conventional techniques. In connection with this, it is very difficult with such techniques to increase the integration density of a mother board.

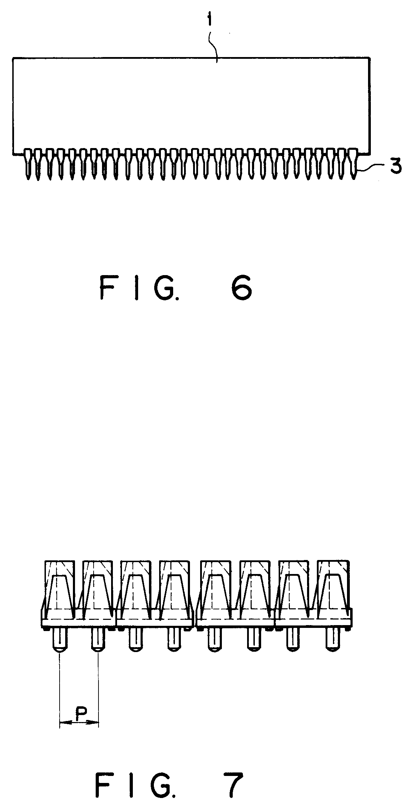

It should be noted here that there are SIMMs of a type to which leads 3 are fixed onto a print substrate 1 itself so that the print substrate is directly set to a via-hole, as shown in Fig. 6. However, it is still very difficult, with this type also, to arrange memory ICs and the like at a high density due to the thicknesses of the SOJ and SOP mounted on the print substrate 1.

The present invention has been proposed to solve the above-mentioned problems, and the purpose thereof is to increase integration of memory ICs and other elements in an arrangement, and decrease the size of the system as a whole, by reducing the socket pitch.

To achieve the above purpose, the thin-type memory module according to the present invention comprises a substrate to be set to a socket provided on a mother board, and semiconductor devices each made of a thin-type package, mounted on one of or both surfaces of said substrate.

Further, the thin-type memory module according to the present invention comprises a substrate to be inserted to a socket provided on a mother board, and semiconductor devices each made of a thin-type small outline package, mounted on one of or both surfaces of said substrate.

This invention can be more fully understood from the following detailed description when taken in conjunction with the accompanying drawings, in which:

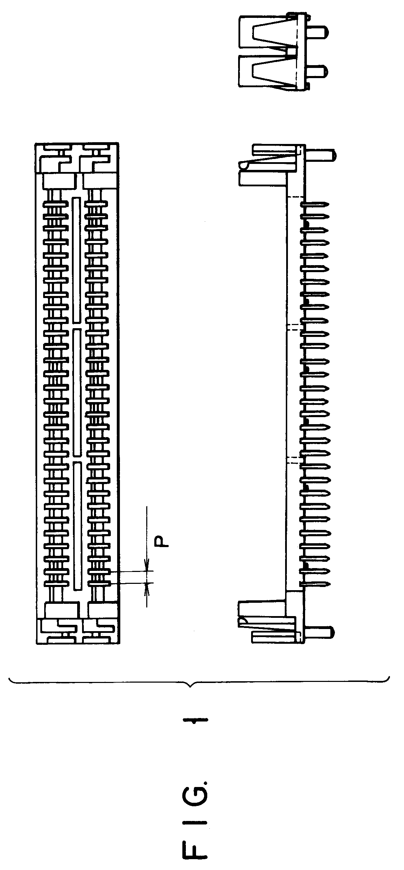

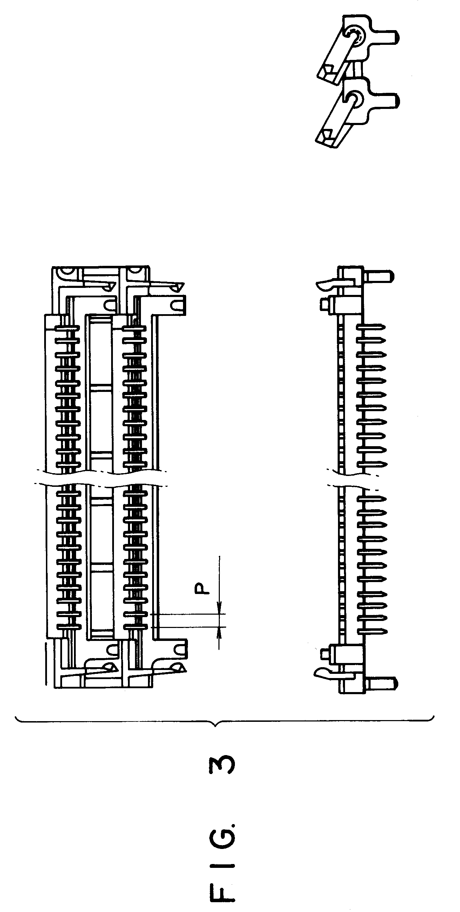

Figs. 1 to 3 show conventional sockets;
Figs. 4 to 6 show conventional SIMMs; and
Figs. 7 to 9 show side views of examples of the sockets to which thin-type memory modules of the present invention are set.

An embodiment of the present invention will now be described with reference to accompanying drawings.

The SIMM of the present invention has a structure in which thin-type packages, such as thin-type package small outline packages (TSOP), are mounted onto one of or both sides of a print substrate. The definition of a thin-type package is that of the total thickness of the stand-off of the package and the mold resin is no more than 1.2 mm. When thin-type package are used, the thickness of an SIMM onto which such packages are mounted can be made less than the conventional ones, and therefore the socket pitch thereof can be reduced. Accordingly, an increase in integration of arrangement of substrates can be achieved, and the size of the system can be decreased.

Fig. 7 shows eight one-side mount sockets provided on a mother board. An SIMM on which thin-type packages are set is engaged with each of these sockets. According to this structure, the following effect can be obtained.

Assume that eight one-side mounting sockets are provided on a mother board, and conventional SIMMs of a type by which two sockets are regarded as a pair, are used. In this case, the width H of a socket pair is

2

14.99 mm (average), and therefore a mount space S for mounting the eight one-side mount sockets is given by:

$$S = 4 \times H = 59.96 \text{ mm} \qquad (1)$$

Further, as is shown in Fig. 1, the thickness $A_1$ of a one-side mount type SIMM to which 1MDRAMs are set 4.97 mm (average); therefore when the pitch P of a socket is 7.62 mm, the distance $D_1$ between adjacent pair of SIMMs is given by:

$$D_1 = P - A_2 = 2.45 \text{ mm} \qquad (2)$$

As can be seen also in Fig. 1, the thickness $A_2$ of a one-side mount type SIMM to which 4MDRAMs are mounted is 5.17 mm (average); therefore when the pitch P of a socket is 7.62 mm, the distance $D_2$ between adjacent pair of SIMMs is given by:

$$D_2 = P - A_2 = 2.45 \text{ mm} \qquad (3)$$

Thus, the average distance D of adjacent pair of SIMMs is, from equations (2) and (3), given by:

$$D = (D_1 + D_2)/2 = 2.55 \text{ mm} \qquad (4)$$

In the meantime, as is shown in Table 1 below, the thickness $A_3$ of a one-side mount type SIMM to which TSOPs are set is 2.77 mm (average). Therefore, when the pitch P of a socket is 7.62 mm, the distance $D_3$ of adjacent pair of SIMMs is given by:

$$D_3 = P - A_3 = 4.85 \text{ mm} \qquad (5)$$

Further, if the distance between adjacent pair of SIMMs is set to the above-obtained average distance D, the number of SIMMs which can be arranged in the above mount space S is given by:

$$A3 \bullet X + D(X-1) = S$$

Therefore, $X = 12$

In other words, when SIMMs to which TSOPs are set are employed, the mounting density can be increased by about 1.5 times as much in the same area as that of the conventional ones.

Table 1

| Package Loaded in Substrate | Thickness of SIMM (mm) |
| :---: | :---: |
| 1M DRAM | 4.97 |
| 4M DRAM | 5.17 |
| TSOP | 2.17 |

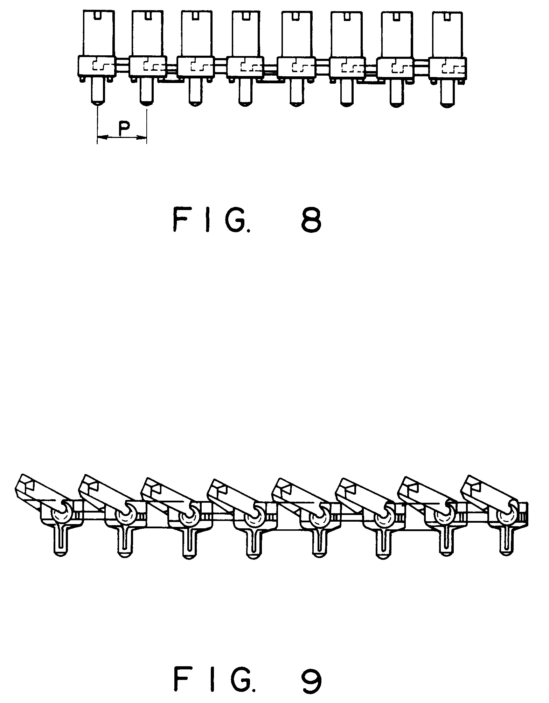

Fig. 8 shows eight both-side mount sockets provided on a mother board. An SIMM to which thin-type packages are set is engaged with each of these sockets. According to this structure, the following effect can be obtained.

Assume that eight both-side mount sockets are provided on a mother board, and conversional SIMMs are used. In this case, the mount space S for the eight one-side mounting sockets is:

$$S = 78.49 \text{ mm} \qquad (6)$$

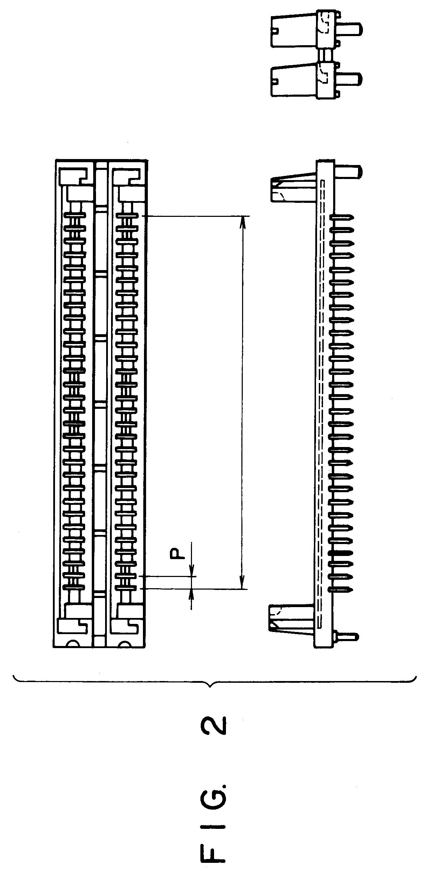

Further, as is shown in Fig. 2, the thickness $A_1$ of a both-side mount type SIMM on which 1MDRAMs are mounted is 8.67 mm (average); therefore when the pitch P of the socket is 10.16 mm, the distance $D_1$ between adjacent pair of SIMMs is given by:

$$D_1 = P - A_2 = 1.49 \text{ mm} \qquad (7)$$

3

As can be seen also in Fig. 1, the thickness $A_2$ of a both-side mount type SIMM to which 4MDRAM are set is 9.07 mm (average); therefore when the pitch P of the sockets is 10.16 mm, the distance $D_2$ between adjacent pair of SIMMs is given by:

$$D_2 = P - A_2 = 1.09 \text{ mm} \qquad (8)$$

Thus, the average distance D of adjacent pair of SIMMs is, from equations (2) and (3), given by:

$$D = (D_1 + D_2)/2 = 1.29 \text{ mm} \qquad (9)$$

In the meantime, the thickness $A_3$ of a both-side mount type SIMM to which TSOPs are set is 4.27 mm (average). Therefore, when the pitch P of the sockets is 10.16 mm, the distance $D_3$ between adjacent pair of SIMMs is given by:

$$D_3 = P - A_3 = 5.89 \text{ mm} \qquad (10)$$

Further, if the distance of adjacent pair of SIMMs is set to the above-obtained average distance D, the number of SIMMs which can be arranged in the above mount space S is given by:

$$A_3 \cdot X + D(X-1) = S$$

Therefore, $X = 14$

In other words, when SIMMs on which TSOPs are mounted are employed, the mounting integration can be increased by about 1.75 times as much in the same area as that of the conventional one.

Table 2

| Package Loaded in Substrate | Thickness of SIMM (mm) |
| --- | --- |
| 1M DRAM | 8.67 |
| 4M DRAM | 9.07 |
| TSOP | 4.27 |

Fig. 9 shows eight both-side mount sockets provided onto a mother board. According to this structure, if SIMMs to which TSOPs are set are employed, the mounting integration can be significantly increased.

Needles to say, the present invention can be applied to SIMMs having a structure shown in Fig. 6.

**Claims**

1. A thin-type memory module characterized by comprising:
   a substrate to be set to a socket provided on a mother board; and
   semiconductor devices each made of a thin-type package, mounted on one of or both surfaces of said substrate.

2. A thin-type memory module according to claim 1, characterized in that said each semiconductor device is of a thin-type small outline package.

3. A thin-type memory module according to claim 1, characterized in that said each semiconductor device is of a thin-type small outline package a thickness of which defined between a surface of said substrate and an upper most portion of said package is no more than 1.2 mm.

F I G. 1

FIG. 2

FIG. 3

FIG. 4    FIG. 5

FIG. 6

FIG. 7

FIG. 8

FIG. 9